(19) Europäisches Patentamt
European Patent Office
Office européen des brevets

(11) Publication number: **0 111 758 B1**

(12) **EUROPEAN PATENT SPECIFICATION**

(45) Date of publication of patent specification: **08.04.87**

(51) Int. Cl.[4]: **C 30 B 19/12,** C 30 B 29/40

(21) Application number: **83111436.8**

(22) Date of filing: **15.11.83**

(54) **Liquid phase epitaxial growth method.**

(30) Priority: **22.11.82 JP 204816/82**

(43) Date of publication of application: **27.06.84 Bulletin 84/26**

(45) Publication of the grant of the patent: **08.04.87 Bulletin 87/15**

(84) Designated Contracting States: **DE FR GB**

(56) References cited:
**JAPANESE JOURNAL OF APPLIED PHYSICS, vol. 21, no. 4, part 2, April 1982, pages L237-L239, Tokyo, JP K. NAKAJIMA et al.: "Direct LPE growth of InP on (111)A oriented InO.53GaO.47 as without dissolution"**
**JOURNAL OF CRYSTAL GROWTH, vol. 27, 1974, pages 142-147, North-Holland Publishing Co. M. G. ASTLES et al.: Nucleation and growth of Gal-xAlxAs ON (111) GaP"**
**APPLIED PHYSICS LETTERS, vol. 41, no. 2, July 1982, pages 194-196, American Institute of Physics, New York, US, K. NAKAJIMA et al.: "Liquid phase epitaxial growth of lattice-matched A10.48 InO.52As on InP"**

(73) Proprietor: **FUJITSU LIMITED**
**1015, Kamikodanaka Nakahara-ku**
**Kawasaki-shi Kanagawa 211 (JP)**

(72) Inventor: **Nakajima, Kazuo**
**1053, Takaishi Asao-ku**
**Kawasaki-shi Kanagawa. 215 (JP)**
Inventor: **Tanahashi, Toshiyuki**
**1158-1014, Tsumada**
**Atsugi-shi Kanagawa. 243 (JP)**

(74) Representative: **Seeger, Wolfgang, Dipl.-Phys.**
**European Patent Attorney Bereiteranger 15**
**D-8000 München 90 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Field of the invention

The present invention relates to a method of growing III—V compound semiconductor by using liquid phase epitaxial growth, more particularly to a liquid phase epitaxial growth of lattice matched aluminium-indium-arsenide ($Al_xIn_{1-x}As$), aluminium-gallium-indium-arsenide ($Al_xGa_yIn_{1-x-y}As$) crystal to indium phosphide (InP) crystal.

Description of prior art

The aluminium-indium-arsenide compound ($Al_xIn_{1-x}As$) crystal realizes the lattice matching to the indium phosphide compound (InP) crystal when x=0.48 and its forbidden band gap is about 1.45 [eV] which is larger than that (about 1.35) of InP.

Therefore, when the $Al_{0.48}In_{0.52}As$ crystal is used in place of the conventional InP crystal or together with it to the carrier confining layer of a semiconductor light emitting device where the InP crystal is used as a substrate and for example the indium-gallium-arsenic-phosphide (InGaAsP) or indium-gallium-arsenide (InGaAs) crystal is used as an active layer, or to the window layer of a semiconductor photo detector device where these crystals are used as the photo absorbing layer, it is expected to improve the performance of these photo semiconductor devices.

Moreover, the AlInAs has Schottky barrier height which is larger than that, for example, of InP or InGaAs, showing the possibility of its application in a Schottky gate field effect transistor etc.

Meanwhile, an aluminium-gallium-indium-arsenide compound ($Al_xGa_yIn_{1-x-y}As$) crystal is capable of realizing lattice matching to the InP crystal in case it is formed with a series of composition ratio ranged as $0<x<0.48$, $0<y<0.47$, and its forbidden band gap ranges from about 0.74 to 1.45 [eV].

This forbidden band gap is rather wider than that (about 0.74 to 1.35 [eV]) of composition ratio which realizes lattice matching between the InGaAsP crystal and InP crystal, and the $Al_{0.48}In_{0.52}As$ and $Al_xGa_yIn_{1-x-y}As$ are now expected for a wide range of application. For example, a light emitting device which emits the light in the wavelength of 0.85 (μm) to 1.68 (μm) or a photo detector device having photo sensitivity within this range may be obtained by combining $Al_{0.48}In_{0.52}As$ and $Al_xGa_yIn_{1-x-y}As$.

In regard to the hetero epitaxial growth of the $Al_{0.48}In_{0.52}As$ crystal to the InP crystal plane, an example using the molecular beam epitaxial growth method has already been proposed. Meanwhile, the liquid phase epitaxial growth method has also been proposed by the inventor of this application in Appl, Phys, Lett, 41, 194 (1982). In addition, liquid phase epitaxial growth of $Al_xGa_yIn_{1-x-y}As$ crystal to the InP crystal plane has also been proposed by the inventor of this application in J, Crystal Growth 54, 232 (1981). In these examples of the epitaxial growth on the InP crystal of the AlInAs or AlGaInAs crystals, the crystal is grown on the (100) plane of InP crystal. However, when these crystals, particularly AlInAs are formed by the liquid phase epitaxial growth on the (100) crystal plane of InP, many crystal defects reaching the surface of AlInAs layer are generated as can be seen in a microphotograph.

The cause of such crystal defects are deemed as follows. Intrinsically, a three-element liquid of Al-In-As or four-element liquid of Al-Ga-In-As which are growth liquids of these crystals is not equilibrated with the two-element solid phase InP crystal. Moreover it is difficult to super cool these growth liquids and therefore the InP crystal is easily soluble to these growth liquids. On the other hand, the atomic fraction of Al, $X^l_{Al}$, in these growth liquids is usually as very small as $5\times10^{-4}$ to $8\times10^{-4}$ and the AlInAs or AlGaInAs crystal shows a low crystal growth rate particularly when the composition ratio of Al is large. For example, about three minutes are required for liquid phase growth of 0.1 [μm] of the AlInAs under a temperature of 780°C.

Therefore, a crystal such as AlInAs gradually increases its thickness after the InP crystal is placed in contact with these growth liquids and the InP crystal dissolves into the liquid. Particularly, a defective area such as a dislocated part quickly dissolves expanding defective area and thereby many defects are deemed to occur in the AlInAs or AlGaInAs crystals grown on the InP crystal.

It is considered to raise, for example, the growth temperature in order to promote crystal growth of AlInAs etc. But, if the growth temperature rises, decomposition of phosphorus (P) from the InP crystal is accelerated and defects of AlInAs crystal further increase.

Summary of the invention

It is an object of the present invention to provide a method of manufacturing an $Al_xIn_{1-x}As$ crystal or $AlGa_yIn_{1-x-y}As$ crystal realizing lattice matching to InP crystal by the liquid phase epitaxial growth method without generation of aforementioned crystal defects.

This object can be attained by the methods of claims 1 to 6. Further advantageous features of the invention are described in claim 7.

The (111)A plane of crystal such as InP is chemically very stable as compared, for example, with the (100) plane or (111)B plane etc. It is understood because its etching speed is low, for example, as compared with other crystals. In case of this invention, when the growth liquid of Al-In-As or Al-Ga-In-As is in contact with the (111)A crystal plane, no melt-back occurs.

Brief description of the drawings

The present invention will become more apparent from the description of the preferred embodiments set forth below, with reference to the accompanying drawings, wherein:

Fig. 1 shows lattice constants of $Al_xIn_{1-x}As$ layers grown on (111)A and (100) InP substrates,

Fig. 2 shows lattice constants of $Al_xGa_yIn_{1-x-y}As$ layers grown on (111)A and (100) InP substrates,

Fig. 3 shows solution composition for LPE growth of lattice-matched $Al_{0.48}In_{0.52}As$ and $Al_xGa_yIn_{1-x-y}As$ layers with various compositions,

Fig. 4 shows a typical PL spectrum of an $Al_xGa_yIn_{1-x-y}As$ layer,

Fig. 5 shows energy gap of $Al_xIn_{1-x}As$ grown on InP (111)A and (100) substrate as a function of $X^l_{Al}$,

Fig. 6 shows energy gap of lattice-matched (111)A-oriented $Al_xGa_yIn_{1-x-y}As$ layers as a function of $X^l_{Al}$ at 685°C and 790°C,

Fig. 7 shows typical surfaces of $Al_xIn_{1-x}As$ grown on (100) InP and (111)A InP,

Fig. 8 shows typical surfaces of $Al_xIn_{1-x}As$ grown on (100) InP and (111)A InP,

Fig. 9 shows layer thickness of lattice-matched $Al_{0.48}In_{0.52}As$ and $Al_xGa_yIn_{1-x-y}As$ grown on (111)A InP,

Fig. 10 shows layer thickness of $Al_xIn_{1-x}As$ grown for 1 min. as a function of the starting growth temperature,

Fig. 11 shows an AlGaInAs/AlInAs/AlGaInAs/(111)A InP heterostructure,

Fig. 12 shows an InGaAs/AlIn/As/(111)A InP heterostructure,

Fig. 13 shows a multilayer structure consisting of AlInAs and AlGaInAs grown on (111)A InP,

Fig. 14 shows an $O_2^+$/SIMS depth profiling measurements of $^{71}Ga$ in the multilayer structure wafer consisted of AlInAs and AlGaInAs, and

Fig. 15 is a microphotograph indicating the surface condition of a crystal of the present invention.

LPE growth conditions for lattice-matching. $Al_xIn_{1-x}As$ and $Al_xGa_yIn_{1-x-y}As$ epitaxial layers were grown onto InP (111)A and (100) substrates by the LPE method. A (100) substrate is used as a control sample for comparison. The solution compositions for the growth were determined on the basis of the previously calculated phase diagrams. These values are listed in Tables I and II. The experimental apparatus consisted of a horizontal furnace system and a conventional sliding graphite boat as reported previously. Pd-purified $H_2$ flowed through the fused silica tube set in the furnace. Materials used were semiconductor grade Al, In, GaAs and InAs. AlIn mother alloy which contained 0.1 atomic percent (a/o) Al was used as the Al source because it was very difficult to dissolve Al into In melts directly at the growth temperatures, due to the miscibility gap in the liquid state of the Al and In binary system.

At the start of the growth run, the furnace was heated rapidly to 30°—40°C above the starting growth temperature, and the growth solution was held there for about 30 min. It was then cooled with a constant cooling rate of 0.5°C/min. Prior to growth, the thermal damage of the surface of the InP substrates was removed using an undersaturated In+P solution.

For the growth of $Al_xIn_{1-x}As$, 685°, 770° and 790°C were used as the starting growth temperatures. The exact amount of supercooling is not clear because of the lack of an experimental phase diagram, but it is sure that the epitaxial layers were grown from supercooled solutions. When the growth temperature interval was 9°C, the thickness of epitaxial layers grown on InP (111)A substrates was 0.1 and 0.5 μm for the starting growth temperatures of 685° and 790°C, respectively.

Lattice constants of these layers were measured by a double crystal x-ray diffraction technique.

TABLE I

Starting growth temperatures, solution compositions, substrate orientations, lattice constants a (Å) and energy gaps $E_g$ (eV) at 300 K for $Al_xIn_{1-x}As$ grown on InP substrates ($1Å=10^{-1}$ mm)

| Starting growth temperature (°C) | Solution compositions | | | | | |
|---|---|---|---|---|---|---|
| | $X^l_{Al}$ | $X^l_{As}$ | $X^l_{In}$ | Face | a (Å) | $E_g$ (eV) |
| 685 | 0.00026 | 0.077 | 0.92274 | (111)A | 5.886 | — |
| | 0.00027 | 0.076 | 0.92373 | | 5.881 | — |
| | 0.00030 | 0.070 | 0.9297 | | 5.864 | — |
| 770 | 0.00067 | 0.1399 | 0.85943 | (111)A | 5.8825 | 1.425 |
| | 0.00068 | 0.139 | 0.86032 | | 5.885 | 1.431 |
| | 0.00070 | 0.138 | 0.8613 | | 5.880—5.882 | 1.437 |
| | 0.00073 | 0.134 | 0.86527 | | 5.870 | 1.443 |
| 790 | 0.00075 | 0.162 | 0.8372 | (111)A | 5.914 | — |
| | 0.00080 | 0.157 | 0.8422 | | 5.885 | — |
| | 0.00085 | 0.152 | 0.8471 | | 5.870—5.872 | 1.44 |
| | 0.00090 | 0.147 | 0.8521 | | 5.861 | — |

TABLE II
Starting growth temperatures, solution compositions, substrate orientations, lattice constants a (Å) and energy gaps $E_g$ (eV) at 300 K for $Al_xGa_yIn_{1-x-y}As$ grown on InP substrates

| Starting growth temperature (°C) | Solution compositions | | | | Face | a (Å) | $E_g$ (eV) |
|---|---|---|---|---|---|---|---|
| | $X^l_{Al}$ | $X^l_{Ga}$ | $X^l_{In}$ | $X^l_{As}$ | | | |
| 685 | 0.00012 | 0.025 | 0.07795 | 0.89693 | (111)A | 5.866—5.870 | 0.8305 |
| | 0.00012 | 0.030 | 0.07514 | 0.89474 | | 5.858 | 0.7858 |
| | 0.00015 | 0.015 | 0.0776 | 0.90725 | | 5.879 | 1.033 |
| | 0.00015 | 0.020 | 0.0750 | 0.90485 | | 5.865 | 0.960 |
| 790 | 0.0003 | 0.020 | 0.8097 | 0.170 | (111)A | 5.931 | — |
| | 0.0003 | 0.025 | 0.8077 | 0.167 | | 5.919 | — |
| | 0.0003 | 0.038 | 0.8047 | 0.157 | | 5.862—5.867 | 0.808 |
| | 0.0003 | 0.040 | 0.8037 | 0.156 | | 5.863 | 0.793 |
| | 0.0004 | 0.020 | 0.8206 | 0.159 | | 5.884—5.878 | 1.057 |
| | 0.0004 | 0.025 | 0.8196 | 0.155 | | 5.873 | 1.010 |
| | 0.0004 | 0.030 | 0.8186 | 0.151 | | 5.865—5.859 | 0.887 |
| | 0.0005 | 0.010 | 0.8345 | 0.155 | | 5.877—5.884 | 1.240 |
| | 0.0005 | 0.014 | 0.8345 | 0.151 | | 5.873 | 1.028 |
| | 0.0005 | 0.016 | 0.8335 | 0.150 | | 5.866 | 1.040 |
| | 0.0006 | 0.003 | 0.8489 | 0.1475 | | 5.868 | 1.352 |
| | 0.0006 | 0.005 | 0.8484 | 0.146 | | 5.862 | 1.259 |
| | 0.0006 | 0.008 | 0.8474 | 0.144 | | 5.857 | 1.252 |
| 790 | 0.0005 | 0.007 | 0.8355 | 0.157 | (100) | 5.878 | 1.288 |
| | 0.0005 | 0.010 | 0.8345 | 0.155 | | 5.873 | 1.269 |
| | 0.0005 | 0.015 | 0.8335 | 0.151 | | 5.850 | 1.277 |

The measured results are listed in Table I. Figure 1 shows the lattice constant of $Al_xIn_{1-x}As$ epitaxial layers grown on InP (111)A substrates starting from 685°, 770°, and 790°C as a function of $X^l_{Al}$, where $X^l_i$ represents the atomic fraction of the element i in the solution. The broken line represents the lattice constant of InP. Figure 1 also shows the previously determined lattice constant of $Al_xIn_{1-x}As$ layers grown on InP (100) substrates. The starting growth temperature was between 790° and 770°C. When $Al_xIn_{1-x}As$ layers were grown from solutions with the same composition, the lattice constant of a layer grown on the (111)A face is larger than that of a layer grown on the (100) face. The solution compositions for the growth of lattice-matched $Al_{0.48}In_{0.52}As$ on InP can be determined from Fig. 1.

For the growth of $Al_xGa_yIn_{1-x-y}As$, 685° and 790°C were used as the starting growth temperatures. The quaternary epitaxial layers were grown on InP (111)A and (100) substrates. Lattice constants of these layers were also determined from the (400) and (333) $CuK\alpha_1$ reflections by using the double crystal x-ray diffraction technique. The precise diffraction angle of the layers was determined by using the substrate reflection as an internal standard. The results are listed in Table II. Figure 2 shows the lattice constant of $Al_xGa_yIn_{1-x-y}As$ layers grown on InP (111)A and (100) substrates starting 685° and 790°C. The growth

solutions containing $X^l_{Al}$=0.00012 and 0.00015 at 685°C, and $X^l_{Al}$=0.0003, 0.0004, 0.0005, and 0.0006 at 790°C were used for the (111)A face. The growth solution with $X^l_{Al}$=0.0005 was used for the (100) face. When $Al_xGa_yIn_{1-x-y}As$ layers were grown from solutions with the same composition, the lattice constant of a layer grown on the (111)A face is also larger than that of a layer grown on the (100) face. The solution compositions for the growth of lattice-matched $Al_xGa_yIn_{1-x-y}As$ on InP can be found from Fig. 2.

Figure 3 shows solution compositions, $X^l_{Ga}$, $X^l_{As}$, and $X^l_{Al}$, required for the LPE growth of lattice-matched $Al_{0.48}In_{0.52}As$ and $Al_xGa_yIn_{1-x-y}As$ layers with various compositions. These data were derived from Fig. 1 and 2 and the calculated liquidus isotherms. The starting growth temperatures of 685° and 790°C were used. As shown in Fig. 3, $X^l_{Ga}$ and $X^l_{As}$ decrease as $X^l_{Al}$ increases. When growth solutions have the same $X^l_{Al}$, $X^l_{Ga}$ is smaller for the (100) face than for the (111)A face. The data for $X^l_{Ga}$=0.0 give the solution compositions for the growth of lattice-matched $Al_{0.48}In_{0.52}As$ on InP.

Energy gaps of lattice-matched alloys.—The energy gap of undoped $Al_xIn_{1-x}As$ and $Al_xGa_yIn_{1-x-y}As$ layers was determined by photoluminescence (PL) measurements at 300 and 77 K. A cw 200-mW Ar ion laser at 5145Å was used as optical pumping source. The laser light was chopped at a frequency of 200 Hz and focused on the sample to a spot about 0.5 mm in diameter. For the PL measurements of longer wavelengths than 0.9 μm, a JASCO CT-50 monochromator with a PbS detector cooled at 77 K and a PAR HR-8 lock-in amplifier were used. For the PL measurements of shorter wavelengths than 0.9 μm, a NARUMI RM-21 monochromator with a Si photodiode (HTV S1336) at room temperature and a NF LI-573 lock-in amplifier were used. The measured results are listed in Tables I and II.

A typical PL spectrum of an $Al_xGa_yIn_{1-x-y}As$ layer is shown in Fig. 4. The spectrum was measured at 300 K. The peak wavelength is 1.028 μm. The thickness and lattice constant of the quaternary layer are 0.5 μm and 5.873Å, respectively. This layer was grown on (111)A InP starting from 790°C at a constant cooling rate of 0.5°C/min. The half-width of the PL spectrum shown in Fig. 4 is 57 meV, and this value is comparable to the half-width of the PL spectra of $In_{1-x}Ga_xAs_{1-y}P_y$ layers whose thickness was 1 μm. This means that the composition variation in this $Al_xGa_yIn_{1-x-y}As$ epitaxial layer is not large.

Figure 5 shows the energy gap of $Al_xIn_{1-x}As$ as a function of $X^l_{Al}$. The energy gap of $Al_xIn_{1-x}As$ epitaxial layers grown on InP (111)A and (100) substrates was measured at 300 and 77 K. The starting growth temperature was 770°C for the (111)A face, and it was between 790° and 770°C for the (100) face. The energy gap of lattice-matched $Al_{0.48}In_{0.52}As$ was measured to be 1.44 eV. The energy gap increases gradually with $X^l_{Al}$ for both faces. The energy shift between the energy gaps at 300 and 77 K was found to be 0.06 eV.

Figure 6 shows the energy gap of lattice-matched (111)A oriented $Al_xGa_yIn_{1-x-y}As$ epitaxial layers as a function of $X^l_{Al}$ at 685° and 790°C. The energy gap was measured at 300 K. The energy gap varies abruptly with increasing $X^l_{Al}$ in the range of the wider energy gap than 0.8 eV. The terminal value at $X^l_{Al}$=0.0 corresponds to the value of $In_{0.53}Ga_{0.47}As$, and the terminal values at $X^l_{Al}$=0.00025 and 0.00086 correspond to that of $Al_{0.48}In_{0.52}As$ for the two different growth temperatures. From the information presented in Fig. 3 and 6, the LPE growth conditions for lattice-matched $Al_xGa_yIn_{1-x-y}As$ layers with desired energy gaps can be easily determined.

Hall measurements of unintentionally doped $Al_{0.48}In_{0.52}As$ layers.—The Hall measurements of unintentionally doped $Al_{0.48}In_{0.52}As$ layers were performed at room temperature, and the carrier concentration, n, and Hall mobility, μ, were derived from the measurements. Two samples of 0.5 μm thick $Al_{0.48}In_{0.52}As$ layers grown on Fe-doped semiinsulating ($10^6$ Ω-cm) (111)A InP were used for the Hall measurements. In this growth, no baking methods of growth solutions described previously have been employed to obtain high purity LPE $Al_{0.48}In_{0.52}As$ layers. The results of the Hall measurements were μ=4549 $cm^2/Vsec$ at $n=4.7\times10^{15}$ $cm^{-3}$ and μ=4466 $cm^2/Vsec$ at $n=5.9\times10^{15}$ $cm^{-3}$. These Hall mobilities are the highest reported until now, and these carrier concentrations are the lowest reported until now. The room temperature Hall mobility of $Al_{0.48}In_{0.52}As$ layers grown by MBE was reported by K. Y. Cheng, A. Y. Cho, and W. R. Wagner, Journal of Applied Physics, 52, 6328 (1981). According to their data, the Hall mobility was lower than 800 $cm^2/Vsec$ at $n=1\times10^{17}$ $cm^{-3}$. The Hall mobility and carrier concentration of undoped $Al_{0.48}In_{0.52}As$ has not been reported. However, the Hall mobilities of $Al_{0.48}In_{0.52}As$ grown by LPE are obviously higher than those of $Al_{0.48}In_{0.52}As$ grown by MBE. High purity $Al_{0.48}In_{0.52}As$ layers with carrier concentrations of $5\times10^{15}$ $cm^{-3}$ can be easily obtained by LPE without special purification methods such as the baking technique.

Substrate orientation dependence of surface morphology.—The surface morphology of $Al_{0.48}In_{0.52}As$ and $Al_xGa_yIn_{1-x-y}As$ depends strongly on the orientation of the substrates. For the starting growth temperature of 685°C, the typical surface morphologies of $Al_xIn_{1-x}As$ grown on InP (100) and (111)A substrates are shown in Fig. 7a and b respectively. As shown in Fig. 7a, only small growth islands appear on the surface of the (100) substrate, and it is very difficult to grow an $Al_xIn_{1-x}As$ epitaxial layer all over the (100) surface. However, it is easy to grow an $Al_xIn_{1-x}As$ epitaxial layer on the (111)A substrate as shown in Fig. 7b. For the high starting growth temperature of 790°C, an $Al_xIn_{1-x}As$ epitaxial layer can be grown all over the surface of the (100) InP substrate as shown in Fig. 8a. However, many surface defects often appear on the (100) surface. In order to obtain $Al_xIn_{1-x}As$ epitaxial layers without surface defects, the epitaxial layers must be grown on the (111)A substrates. Figure 8b shows the typical surface on an $Al_xIn_{1-x}As$ layer grown on (111)A InP starting from 790°C. The (111)A surface is very smooth, and such surface defects as shown in Fig. 8a are not observed at all. For the growth of $Al_xGa_yIn_{1-x-y}As$, epitaxial layers with smooth surface can also be easily grown on the (111)A substrates.

The reason why the surface defects easily appear on the (100) surface of $Al_xIn_{1-x}As$ layers is related to the dissolution of the InP (100) substrates. When $Al_xIn_{1-x}As$ layers were completely removed by using a selective etchant of $HF:HNO_3=1:1$, many small holes were observed on the surface of the InP (100) substrates. However, such holes were not observed on the surface of the InP (111)A substrates. As reported previously, the (111)A face is more stable to dissolution than the (100) face. Therefore, the surface defects due to dissolution of the substrates appear more easily on the (100) face than on the (111)A face.

Growth rate of $Al_{0.48}In_{0.52}As$ and $Al_xGa_yIn_{1-x-y}As$.—Figure 9 shows the layer thickness of lattice-matched $Al_{0.48}In_{0.52}As$ and $Al_xGa_yIn_{1-x-y}As$ as a function of $X^l_{Al}$. These layers were grown on InP (111)A substrates by the ramp cooling method. A constant cooling rate of 0.5°C/min was used. The starting growth temperatures were 685° and 790°C, and the cooled temperature interval was 9°C. As shown in Fig. 9, the layer thickness of $Al_xGa_yIn_{1-x-y}As$ increases as $X^l_{Al}$ decreases. This means that the layer thickness of $Al_xGa_yIn_{1-x-y}As$ increases as x (Al content in the alloy) decreases. The growth rate of $Al_{0.48}In_{0.52}As$ ternary layers is the smallest of the Al-Ga-In-As system. The growth rate of $Al_xGa_yIn_{1-x-y}As$ increases rapidly when $X^l_{Al}$ becomes smaller than 0.0005.

Figure 10 shows the layer thickness of $Al_xIn_{1-x}As$ grown for 1 min as a function of the starting growth temperature. The growth was performed on (111)A InP by the ramp cooling method. A constant cooling rate of 0.5°C/min was used. As shown in Fig. 10, the layer thickness per 1 min was only 60Å at 685°C and 240Å at 790°C. Therefore, very thin layers can be grown under good control by using the ordinary LPE growth apparatus with a sliding graphite boat. It is expected that a 40Å thick layer can be grown at 790°C for a growth time of 10 sec.

Growth of heterostructures.—In order to fabricate devices using $Al_{0.48}In_{0.52}As$ or $Al_xGa_yIn_{1-x-y}As$, it is necessary to obtain heterostructures. $Al_xGa_yIn_{1-x-y}As$ can be grown on $Al_{0.48}In_{0.52}As$ without dissolution. $Al_{0.48}In_{0.52}As$ can also be grown on $Al_xGa_yIn_{1-x-y}As$, but the dissolution of $Al_{0.48}In_{0.52}As$ into the Al-Ga-In-As growth solution becomes more severe as the Al content in the quaternary alloy decreases. Figure 11 shows the

$$Al_xGa_yIn_{1-x-y}As/Al_{0.48}In_{0.52}As/Al_xGa_yIn_{1-x-y}As$$

heterostructure grown on (111)A InP. The starting growth temperature was 790°C. The wavelength of the $Al_xGa_yIn_{1-x-y}As$ layers was 1.0 µm at 300 K. $In_{0.53}Ga_{0.47}As$ can be grown on $Al_{0.48}In_{0.52}As$ as shown in Fig. 12. These layers were grown on (111)A InP. $In_{0.53}Ga_{0.47}As$ was grown on $Al_{0.48}In_{0.52}As$ at 650°C by the ramp cooling method. $In_{1-x}Ga_xAs_{1-y}P_y$ can also be grown on $Al_{0.48}In_{0.52}As$, but the growth of $Al_{0.48}In_{0.52}As$ on $In_{0.53}Ga_{0.47}As$ was more difficult.

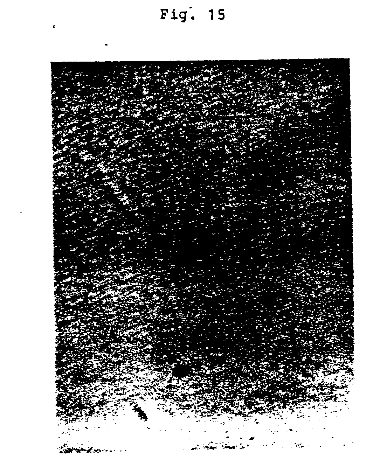

Figure 13 shows a multilayer structure consisting of $Al_{0.48}In_{0.52}As$ and $Al_xGa_yIn_{1-x-y}As$ grown on (111)A InP. The thickness of the $Al_{0.48}In_{0.52}As$ and $Al_xGa_yIn_{1-x-y}As$ layers was about 0.05 µm and 0.1 µm, respectively. The growth was started from 781°C at a constant cooling rate of 0.5°C/min, and the growth time of each layer was 1 min. Since a sightly super-cooled (2°—3°C) solution was used for the growth of $Al_{0.48}In_{0.52}As$ layers, the growth rate was higher than that shown in Fig. 10. The wavelength of the $Al_xGa_yIn_{1-x-y}As$ layers was 0.98 µm at 300 K. Figure 14 shows the $O_2^+$/SIMS depth profile of $^{71}Ga$ from the surface of this sample. As shown in Fig. 14, this sample has 11 layers. The abruptness of the heterointerfaces can not be accurately known from Fig. 14 because of the limit of resolution of SIMS depth profiling measurements. A thinner multilayer structure can be grown by using a shorter growth time.

Example

This invention is explained concretely by way of a first example for growth of the $Al_xIn_{1-x}As$ crystal, a second embodiment for growth of the $Al_xGa_yIn_{1-x-y}As$ and a third embodiment for growth of the $Al_xGa_yIn_{1-x-y}As$ crystal and then the $Al_xIn_{1-x}As$ crystal.

(i) Embodiment for the growth of an $Al_xIn_{1-x}As$ crystal:

A slide boat for ordinary liquid phase epitaxial growth accommodating the InP substrate, melt-back liquid explained later and raw material crystal of growth liquid is placed within a quartz reaction pipe through which the pure hydrogen ($H_2$) is flowed. However, the upper surface of InP substrate is prepared as the (111)A crystal plane and is protected by the InP cover plate.

The internal temperature is raised up to 810°C and is held in such condition for 30 minutes. Thereafter, a temperature is lowered at the cooling rate of 0.3°C/min and the meltback of substrate and growth of the $Al_xIn_{1-x}As$ crystal are executed as follows.

(a) Meltback of InP substrate
Liquid composition:
In:InP=2.1844[g]:0.0695[g]
Temperature: 770°C
Time: About 10 seconds

(b) Growth of AlInAs crystal
Liquid composition: AlIn:InAs:In
=4.0082[g]:1.2207[g]:0.01085[g]

Where, AlIn is a solid solution, containing Al of 0.1 [wt%], namely 0.0235 [wt%] in In. Since Al does not easily dissolve and mixes uniformly into discrete In because of monotectic reaction, an AlIn mother alloy is used.

Atomic fraction of liquid: $X^l_{Al}=0.00073$
$X^l_{In}=0.86527$
$X^l_{As}=0.13400$

Temperature: About 770→764°C

Growth thickness: About 0.46 [μm]

When the growth of the crystal completes, the temperature is rapidly cooled down to a room temperature.

The surface condition of an AlInAs crystal grown by this embodiment is shown in a microphotograph (125 times) of Fig. 15. As is clear from this figure, according to this invention, crystal defects as shown in the prior art shown in Fig. 7 do not appear and the surface condition is excellent.

As a result of measuring the lattice constant of the AlInAs crystal in this embodiment by the X-ray analysis method, the lattice mismatching ratio Δa/a to the InP crystal was as low as $0.3\times10^{-4}$ or less and the peak wavelength of photoluminescence was confirmed as about 0.855 (μm), the forbidden band was 1.45 (eV) and the composition was $Al_{0.48}In_{0.52}As$.

(ii) Embodiment of $Al_xGa_yIn_{1-x-y}As$ crystal growth:

As in the case of the embodiment of said AlInAs crystal growth, the liquid phase growth of the $Al_xGa_yIn_{1-x-y}As$ crystal is executed. In this embodiment, a cooling speed is set to 0.5°C/min.

(a) Meltback of InP substrate:

Liquid composition:In:InP=2.3207 [g]:0.07045 [g]

Temperature: 790°C

Time: About 10 seconds

(b) AlGaInAs crystal growth

Liquid composition: AlIn:InAs:GaAs:In
=2.74588 [g]:1.47505 [g]:0.21630 [g]:1.98785 [g]

Here, AlIn is used because of the same reason as explained above.

Atomic refraction of liquid: $X^l_{Al}=0.0004$
$X^l_{Ga}=0.0250$
$X^l_{In}=0.8196$
$X^l_{As}=0.1550$

Temperature: About 790→781°C

Growth thickness: About 1.92 [μm]

As in the case of the AlInAs crystal surface in the above embodiment, any crystal defect was not observed on the AlGaInAs crystal surface of this embodiment. The lattice matching was also good and the peak wavelength of photo luminescence was about 1.228 [μm].

(iii) Embodiment where $Al_xGa_yIn_{1-x-y}As$ crystal is grown first and then $Al_xIn_{1-x}As$ crystal is grown thereon:

The liquid phase growth is executed as in the case of above embodiments (i) and (ii). The cooling speed in this embodiment is also set to 0.5 [°C/min] as in the case of embodiment (ii).

(a) Meltback of InP substrate

Liquid composition: In:InP=2.22785 [g]:0.0669 [g]

Temperature: 790°C

Time: About 10 seconds

(b) AlGaInAs crystal growth

Liquid composition: AlIn:InAs:GaAs:In
=5.4489 [g]:2.61379 [g]:0.1386 [g]:2.0724 [g]

AlIn is used because of the same reason as explained above.

Atomic fraction of liquid: $X^l_{Al}=0.0005$
$X^l_{Ga}=0.0100$
$X^l_{In}=0.8345$
$X^l_{As}=0.1550$

Temperature: About 790→781°C

Growth thickness: About 0.6 [μm]

Photo luminescence peak wavelength: About 1.0 [μm]

(c) AlInAs crystal growth

Liquid composition: AlIn:InAs:In
=5.79005 [g]:2.3487 [g]:1.0248 [g]

AlIn is used because of the same reason as explained above.

Temperature: 781→773°C

Growth thickness: About 0.5 [μm]

In regard to the AlGaInAs—AlInAs crystal obtained by this embodiment, excellent surface condition and lattice matching are obtained as in the case of the embodiment (i).

As in the case of the embodiment (i) explained above, a good result has been obtained by executing the processes explained below by the liquid phase epitaxial growth method. That InGaAsP crystal, for example, is grown on the InP substrate having the main plane of (111)A and then the $Al_{0.48}In_{0.52}As$ crystal or $Al_xGa_yIn_{1-x-y}As$ crystal is grown on such InGaAsP layer.

As explained above, according to this invention, the $Al_xIn_{1-x}As$ ($x=0.48$) crystal having a forbidden band which is very much larger than that of the material considered as the object of researches in semiconductor devices or the $Al_xGa_yIn_{1-x-y}As$ crystal having a wider and changeable forbidden band gap can be grown without any crystal defect by the liquid phase epitaxial growth method, through lattice matching to the InP which occupies the main part in the III—V group compound semiconductor.

In this invention, a crystal is grown in the (111)A plane and therefore it is adequate to select the (110) plane as the cleavage surface of laser, but the resonant surface of the laser can also be formed since the parallel cleavage surface can be formed by selecting only the same cleavage direction.

Accordingly, a semiconductor light emitting device, photo detector device and various semiconductor devices such as field effect transistor can be formed easily by selecting and combining $Al_xIn_{1-x}As$ and $Al_xGa_yIn_{1-x-y}As$ together with InP, indium-gallium-arsenic/phosphide (InGaAsP) and indium-gallium-arsenide (InGaAs). In this sense this invention contributes much to the development of the III—V group compound semiconductor devices and to the practical use thereof.

**Claims**

1. A liquid phase epitaxial growth method, said method comprising the steps of;
(a) preparing an indium phosphide substrate with a crystal plane (111)A, and
(b) forming an epitaxial layer of an aluminium-indium-arsenide ($Al_xIn_{1-x}As$) by liquid phase epitaxy, where $x=0.48$, on said InP (111)A substrate.

2. A liquid phase epitaxial growth method, said method comprising the steps of;
(a) preparing an indium phosphide substrate with a crystal plane (111)A, and
(b) forming an epitaxial layer of an aluminium-gallium-indium-arsenide ($Al_xGa_yIn_{1-x-y}As$) by liquid phase epitaxy, where $0<x<0.48$, $0<y<0.47$, on said InP (111)A substrate.

3. A liquid phase epitaxial growth method, said method comprising the steps of;
(a) preparing an indium phosphide substrate with a crystal plane (111)A,
(b) forming a first epitaxial layer of aluminium-gallium-indium-arsenide ($Al_xGa_yIn_{1-x-y}As$) by liquid phase epitaxy, where $0<x<0.48$, $0<y<0.47$ on said InP (111)A substrate, and
(c) forming a second epitaxial layer of aluminum-indium arsenide ($Al_xIn_{1-x}As$) by liquid phase epitaxy, where $x=0.48$, on said first epitaxial layer.

4. A liquid phase epitaxial growth method, said method comprising the steps of;
(a) preparing an indium phosphide substrate with a crystal plane (111)A,
(b) forming a first epitaxial layer of aluminium-indium-arsenide ($Al_xIn_{1-x}As$) by liquid phase epitaxy, where $x=0.48$ on said InP (111)A substrate, and
(c) forming a second epitaxial layer of aluminium-gallium-indium-arsenide ($Al_xGa_yIn_{1-x-y}As$) by liquid phase epitaxy, where $0<x<0.48$, $0<y<0.47$, on said first epitaxial layer.

5. A liquid phase epitaxial growth method, said method comprising the steps of;
(a) preparing an indium phosphide substrate with crystal plane (111)A,
(b) forming a first epitaxial layer of InGaAs or InGaAsP having crystal plane (111)A by liquid phase epitaxy on said InP (111)A substrate, and
(c) forming a second epitaxial layer of aluminum-indium-arsenide ($Al_xIn_{1-x}As$) by liquid phase epitaxy where $x=0.48$, on said first epitaxial layer.

6. A liquid phase epitaxial growth method, said method comprising the steps of;
(a) preparing an indium phosphide substrate with crystal plane (111)A,
(b) forming a first epitaxial layer of InGaAs or InGaAsP having crystal plane (111)A by liquid phase epitaxy on said InP (111)A substrate, and
(c) forming a second epitaxial layer of aluminum-gallium-indium-arsenide ($Al_xGa_yIn_{1-x-y}As$), where $0<x<0.48$, $0<y<0.47$, on said first epitaxial layer.

7. A semiconductor structure having a semiconductor layer formed by liquid phase epitaxy, which comprises;
(a) an indium phosphide substrate with crystal plane (111)A, and
(b) an epitaxial layer of an aluminum-indium-arsenide compound semiconductor formed on said substrate by liquid phase epitaxy.

**Patentansprüche**

1. Kristallzuchtverfahren nach der Flüssigphasenepitaxie, welches die folgenden Schritte umfaßt:
(a) Präparation eines Indiumphosphidsubstrats mit einer kristallographischen Ebene (111)A, und

(b) Bildung einer epitaktischen Schicht aus einem Aluminiumindiumarsenid ($Al_xIn_{1-x}As$) durch Flüssigphasenepitaxie auf dem genannten InP-(111)A-Substrat, wobei x=0,48.

2. Kristallzuchtverfahren nach der Flüssigphasenepitaxie, welches Verfahren die folgenden Schitte umfaßt:

(a) Herstellung eines Indiumphosphidsubstrats mit einer kristallographischen Ebene (111)A, und

(b) Bildung einer epitaktischen Schicht aus einem Aluminiumgalliumindiumarsenid ($Al_xGa_yIn_{1-x-y}As$) durch Flüssigphasenepitaxie auf dem genannten InP-(III)A-Substrat, wobei 0<x<0,48, 0<y<0,47.

3. Kristallzuchtverfahren nach der Flüssigphasenepitaxie, welches die folgenden Schritte umfaßt:

(a) Herstellung eines Indiumphosphidsubstrats mit einer kristallographischen Ebene (111)A,

(b) Bildung einer ersten epitaktischen Schicht aus Aluminiumgalliumindiumarsenid ($Al_xGa_yIn_{1-x-y}As$) durch Flüssigphasenepitaxie auf dem genannten InP-(111)A-Substrat, wobei 0<x<0,48, 0<y<0,47, und

(c) Bildung einer zweiten epitaktischen Schicht aus Aluminiumindiumarsenid ($Al_xIn_{1-x}As$) durch Flüssigphasenepitaxie auf der genannten ersten epitaktischen Schicht, wobei x=0,48.

4. Kristallzuchtverfahren nach der Flüssigphasenepitaxie, welches die folgenden Schritte umfaßt:

(a) Präparation eines Indiumphosphidsubstrats mit einer kristallographischen Ebene (111)A,

(b) Bildung einer ersten epitaktischen Schicht aus Aluminiumindiumarsenid ($Al_xIn_{1-x}As$) durch Flüssigphasenepitaxie auf dem genannten InP-(111)A-Substrat, wobei x=0,48, und

(c) Bildung einer zweiten epitaktischen Schicht aus Aluminiumgalliumindiumarsenid ($Al_xGa_yIn_{1-x-y}As$) durch Flüssigphasenepitaxie auf der genannten ersten epitaktischen Schicht, wobei 0<x<0,48, 0<y<0,47.

5. Kristallzuchtverfahren nach der Flüssigphasenepitaxie, welches die folgenden Schritte umfaßt:

(a) Herstellung eines Indiumphosphidsubstrats mit einer kristallographischen Ebene (111)A,

(b) Bildung einer ersten epitaktischen Schicht aus InGaAs, mit einer kristallographischen Ebene (111)A, durch Flüssigphasenepitaxie, auf dem genannten InP-(111)A-Substrat, und

(c) Bildung einer zweiten epitaktischen Schicht aus Aluminiumindiumarsenid ($Al_xIn_{1x}As$), durch Flüssigphasenepitaxie auf der ersten epitaktischen Schicht, wobei x=0,48.

6. Kristallzuchtverfahren nach der Flüssigphasenepitaxie, mit den folgenden Schritten:

(a) Präparation eines Indiumphosphidsubstrats mit einer kristallographischen Ebene (111)A,

(b) Bildung einer ersten epitaktischen Schicht aus InGaAs oder InGaAsP, mit einer kristallographischen Ebene (111)A, durch Flüssigphasenepitaxie auf dem genannten InP-(111)A-Substrat, und

(c) Bildung einer zweiten epitaktischen Schicht aus Aluminiumgalliumindiumarsenid ($Al_xGa_yIn_{1-x-y}As$) auf der ersten epitaktischen Schicht, wobei 0<x<0,48, 0<y<0,47.

7. Halbleiterstruktur mit einer Halbleiterschicht, die durch Flüssigphasenepitaxie gebildet ist, welche umfaßt:

(a) ein Indiumphosphidsubstrat mit einer kristallographischen Ebene (111)A, und

(b) eine epitaktische Schicht aus einem Aluminiumindiumarsenid-Verbindungshalbleiter, der durch Flüssigphasenepitaxie auf dem genannten Substrat gebildet ist.

**Revendications**

1. Procédé de croissance épitaxiale en phase liquide, ce procédé comprenant les étapes suivantes:

(a) préparer un substrat de phosphure d'indium avec un plan cristallin (111)A, et

(b) former une couche épitaxiale d'un arséniure d'aluminium-indium ($Al_xIn_{1-x}As$) par épitaxie en phase liquide, où x=0,48 sur le substrat d'InP (111)A.

2. Procédé de croissance épitaxiale en phase liquide, ce procédé comprenant les étapes suivantes:

(a) préparer un substrat de phosphure d'indium avec un plan cristallin (111)A, et

(b) former une couche épitaxiale d'un arséniure d'aluminium-gallium-indium ($Al_xGa_yIn_{1-x-y}As$) par épitaxie en phase liquide, où 0<x<0,48, 0<y<0,47, sur le substrat d'InP (111)A.

3. Procédé de croissance en phase liquide, ce procédé comprenant les étapes suivantes:

(a) préparer un substrat de phosphure d'indium avec un plan cristallin (111)A,

(b) former une première couche épitaxiale d'arséniure d'aluminium-gallium-indium ($Al_xGa_yIn_{1-x-y}As$) par épitaxie en phase liquide, où 0<x<0,48, 0<y<0,47 sur le substrat d'InP (111)A, et

(c) former une seconde couche épitaxiale d'arséniure d'aluminium-indium ($Al_xIn_{1-x}As$) par épitaxie en phase liquide, où x=0,48, sur la première couche épitaxiale.

4. Procédé de croissance épitaxiale en phase liquide, ce procédé comprenant les étapes suivantes:

(a) préparer un substrat de phosphure d'indium avec un plan cristallin (111)A,

(b) former une couche épitaxiale d'un arséniure d'aluminium-indium ($Al_xIn_{1-x}As$) par épitaxie en phase liquide, où x=0,48 sur le substrat d'InP (111)A, et

(c) former une seconde couche épitaxiale d'arséniure d'aluminium-gallium-indium (($Al_xGa_yIn_{1-x-y}As$) par épitaxie en phase liquide où 0<x<0,48, 0<y< 0,47, sur la première couche épitaxiale.

5. Procédé de croissance épitaxiale en phase liquide, ce procédé comprenant les étapes suivantes:

(a) préparer un substrat de phosphure d'indium avec un plan cristallin (111)A,

(b) former une première couche épitaxiale d'InGaAs ou de InGaAsP ayant un plan cristallin (111)A par épitaxie en phase liquide sur le substrat d'InP (111)A, et

(c) former une seconde couche épitaxiale d'arséniure d'aluminium-indium ($Al_xIn_{1-x}As$) par épitaxie en phase liquide, où x=0,48, sur la première couche épitaxiale.

6. Procédé de croissance épitaxiale en phase liquide, ce procédé comprenant les étapes suivantes:

(a) préparer un substrat de phosphure d'indium avec un plan cristallin (111)A,

(b) former une première couche épitaxiale d'InGaAs ou de InGaAsP ayant un plan cristallin (111)A par épitaxie en phase liquide sur le substrat d'InP (111)A, et

(c) former une seconde couche épitaxiale d'arséniure d'aluminium-gallium-indium ($Al_xGa_yIn_{1-x-y}As$) par épitaxie en phase liquide où $0<x<0,48$, $0<y<0,47$, sur la première couche épitaxiale.

7. Structure semiconductrice comprenant une couche semiconductrice formée par épitaxie en phase liquide, qui comprend:

(a) un substrat de phosphure d'indium avec un plan cristallin (111)A, et

(b) une couche épitaxiale d'un semiconducteur composé d'arséniure d'aluminium-indium formée sur le substrat par épitaxie en phase liquide.

Fig. 1

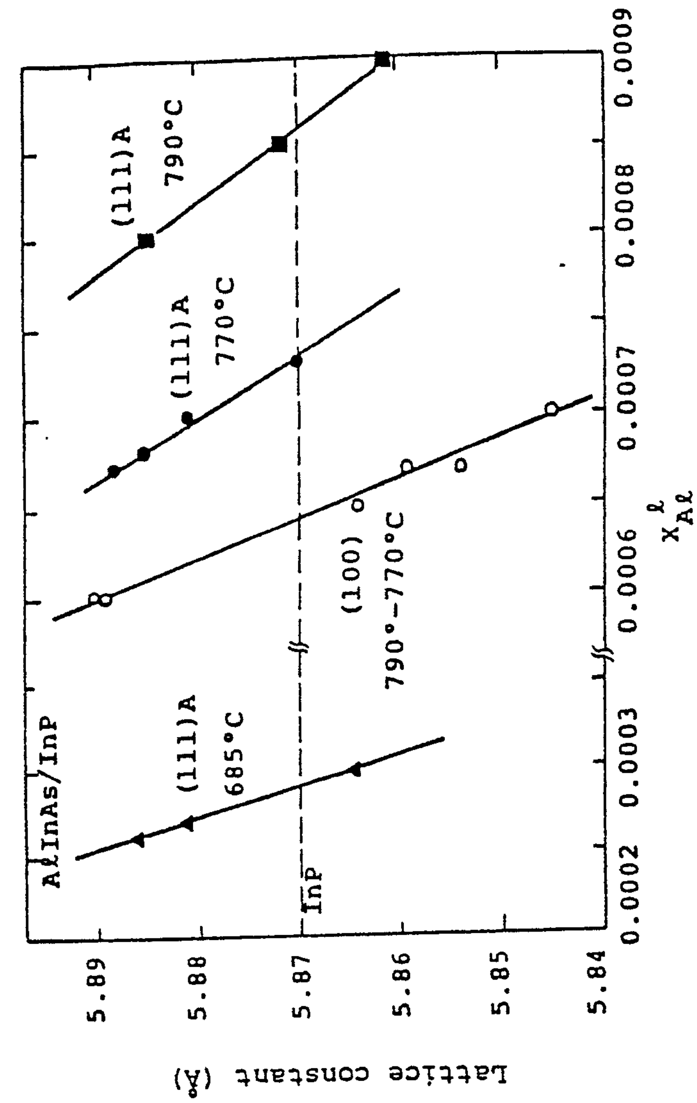

(111)A
790°C
(111)A
770°C
(100)
790°-770°C
(111)A
685°C
AlInAs/InP
InP
5.89
5.88
5.87
5.86
5.85
5.84
Lattice constant (Å)
0.0002
0.0003
0.0006
0.0007
0.0008
0.0009
$X^{l}_{Al}$

Fig. 2

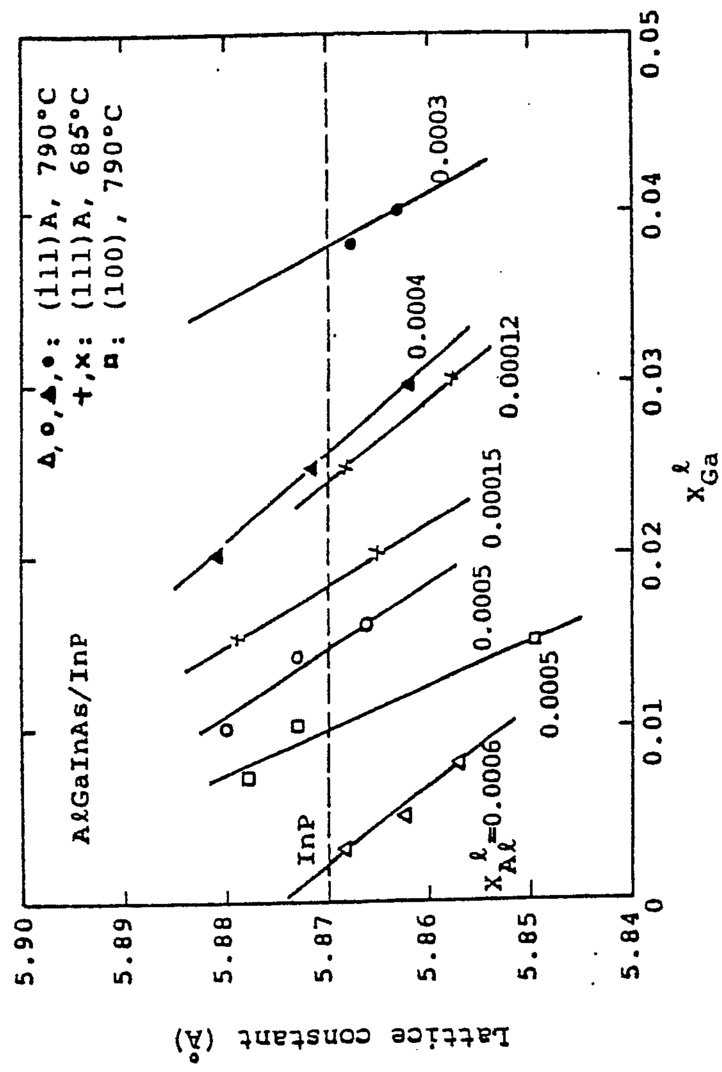

AℓGaInAs/InP
△,○,▲,●: (111)A, 790°C
+,x: (111)A, 685°C
□: (100), 790°C
InP
$X^{\ell}_{A\ell}$=0.0006
0.0005
0.0005
0.00015
0.00012
0.0004
0.0003
Lattice constant (Å)
5.90
5.89
5.88
5.87
5.86
5.85
5.84
$X^{\ell}_{Ga}$
0
0.01
0.02
0.03
0.04
0.05

Fig. 3

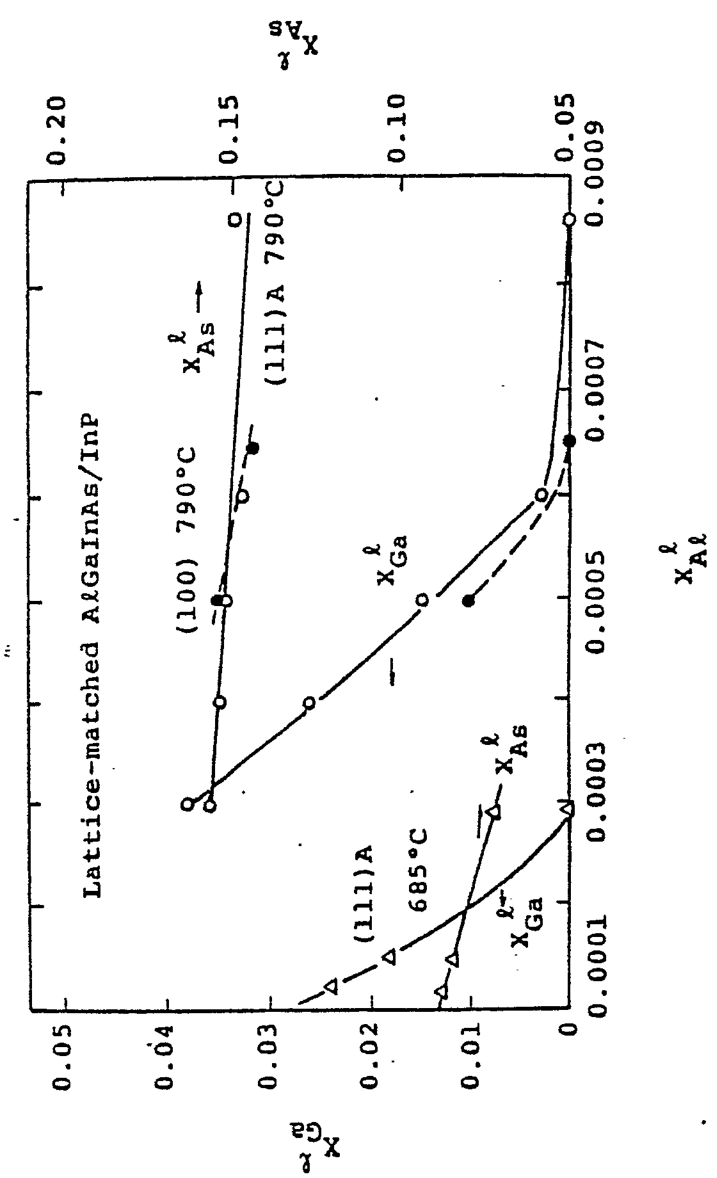
Lattice-matched AℓGaInAs/InP
(100) 790°C
(111)A 790°C
(111)A
685°C
$X^{\ell}_{As}$
$X^{\ell}_{Ga}$
$X^{\ell}_{Aℓ}$
0.0001
0.0003
0.0005
0.0007
0.0009
0
0.01
0.02
0.03
0.04
0.05
0.10
0.15
0.20

Fig. 4

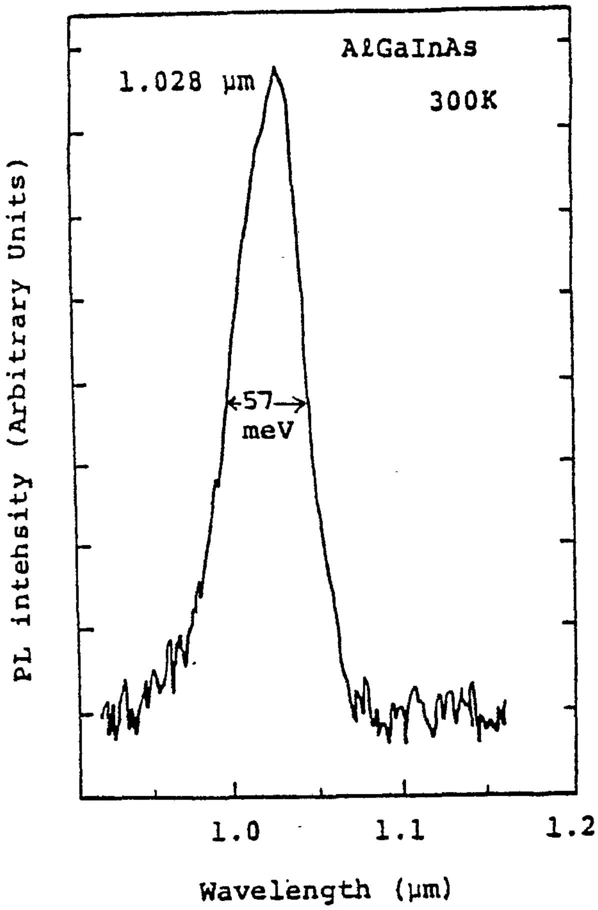
AℓGaInAs
300K
1.028 µm
57
meV
PL intensity (Arbitrary Units)
1.0
1.1
1.2
Wavelength (µm)

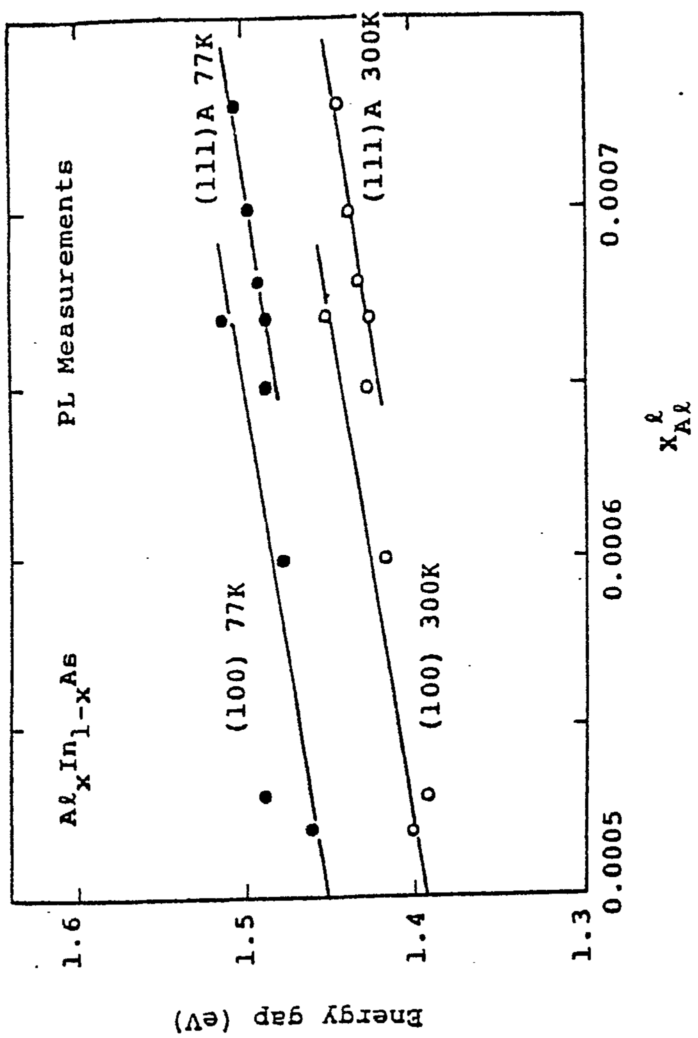

PL Measurements
$Al_xIn_{1-x}As$
(111)A 77K
(111)A 300K
(100) 77K
(100) 300K
1.6
1.5
1.4
1.3
0.0005
0.0006
0.0007
$x^l_{Al}$
Energy gap (eV)


Fig. 5

Fig. 6

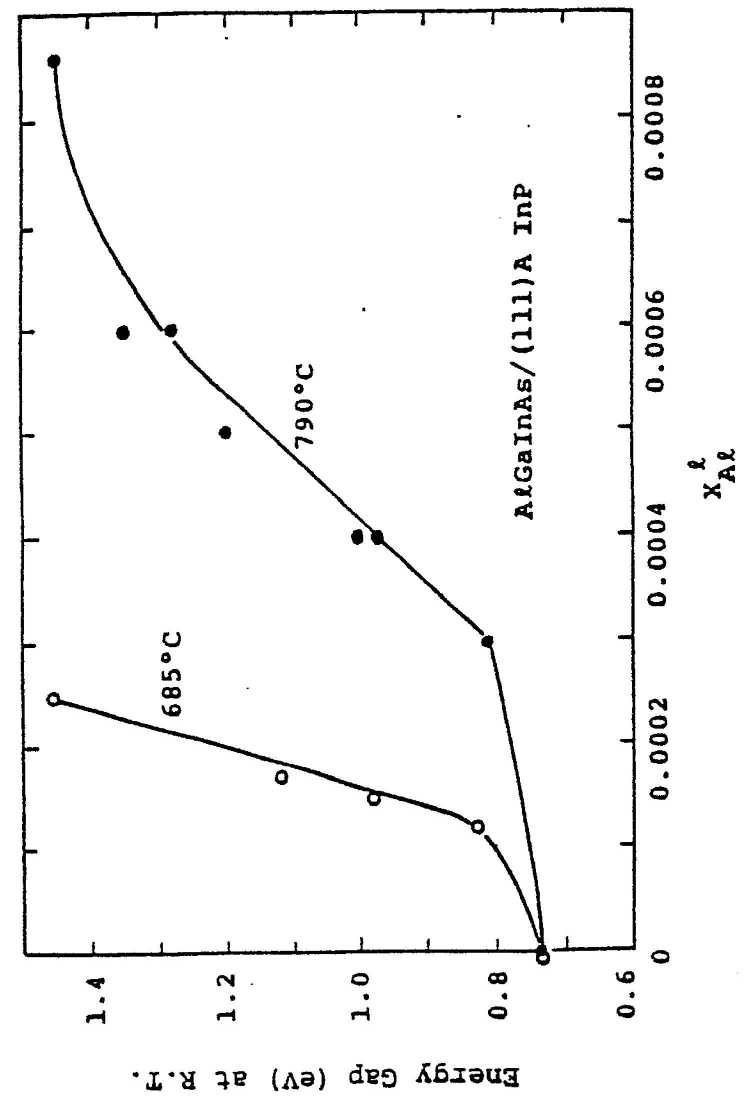

AℓGaInAs/(111)A InP
790°C
685°C
Energy Gap (eV) at R.T.
1.4
1.2
1.0
0.8
0.6
0
0.0002
0.0004
0.0006
0.0008
$X^{\ell}_{A\ell}$

Fig. 7(a)

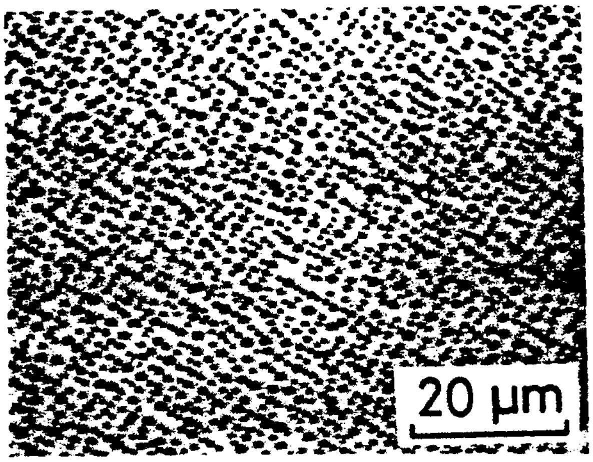


Fig. 7(b)

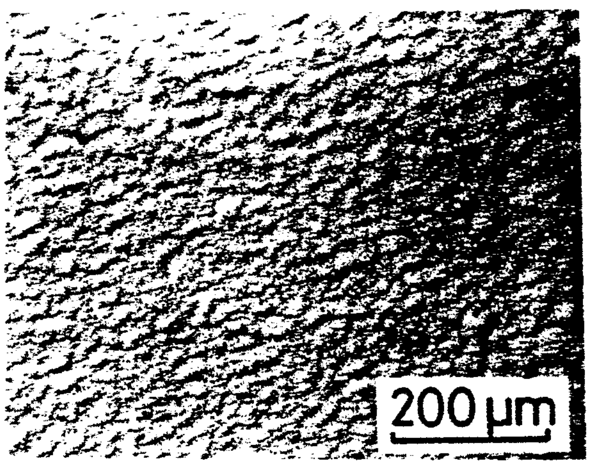

Fig. 8(a)

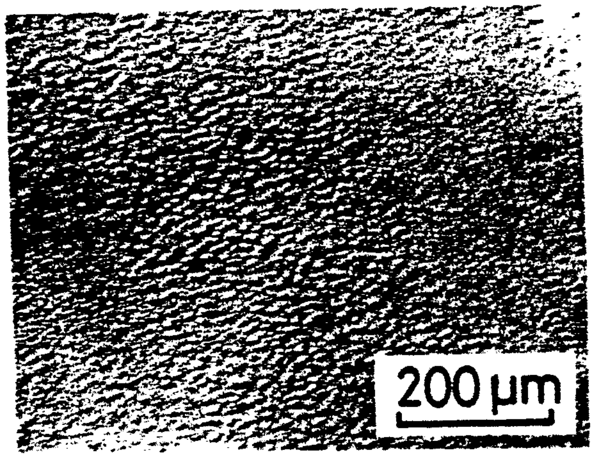


Fig. 8(b)

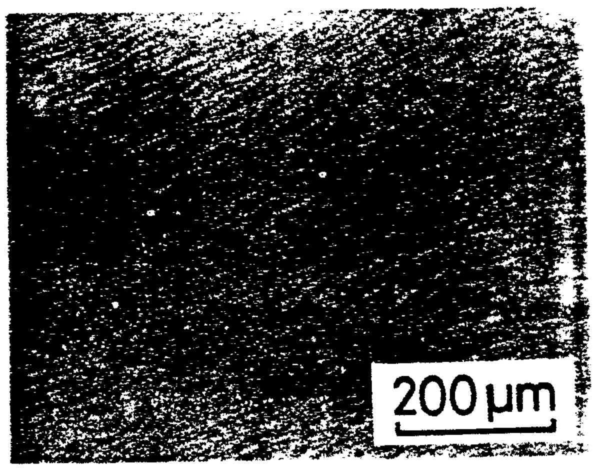

Fig. 9

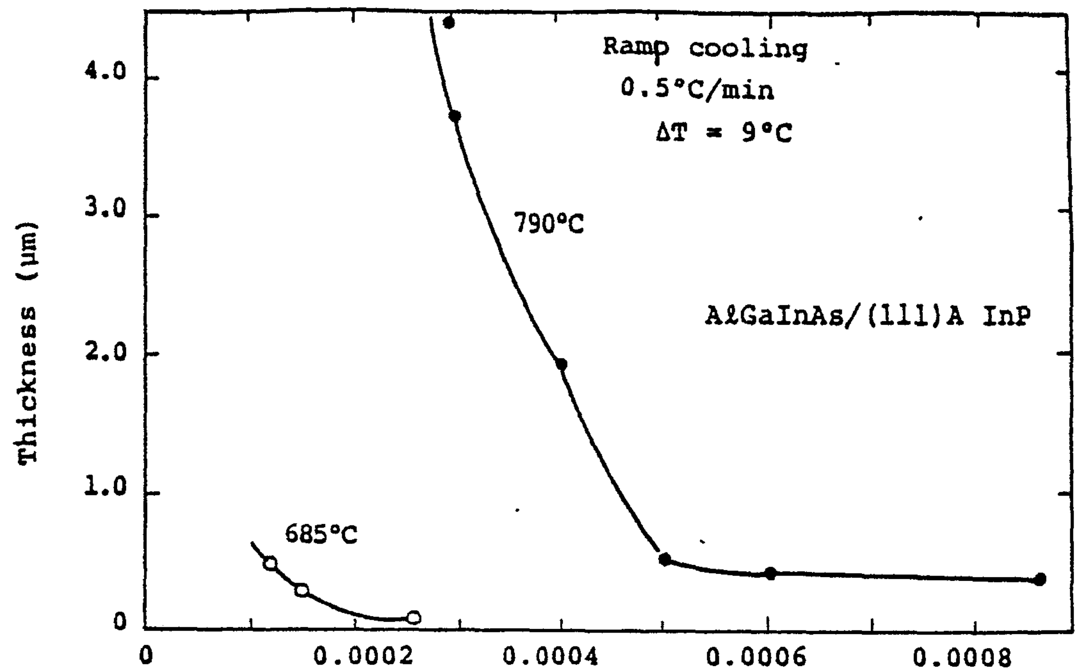
Ramp cooling
0.5°C/min
ΔT = 9°C
790°C
685°C
AℓGaInAs/(111)A InP
Thickness (μm)
4.0
3.0
2.0
1.0
0
0
0.0002
0.0004
0.0006
0.0008

Fig. 10

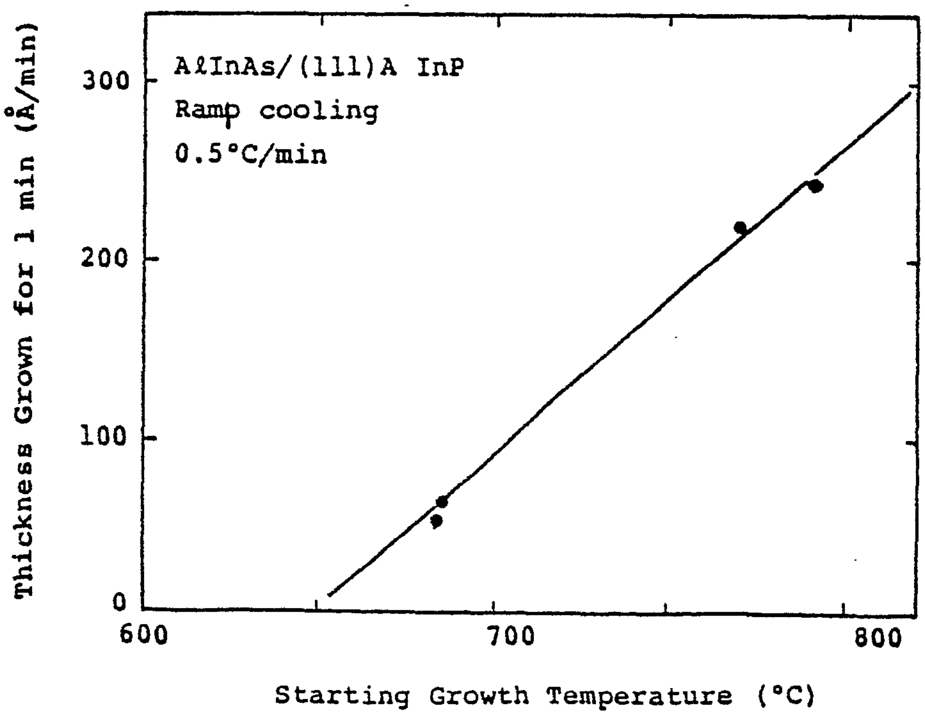
AℓInAs/(111)A InP
Ramp cooling
0.5°C/min
Thickness Grown for 1 min (Å/min)
300
200
100
0
600
700
800
Starting Growth Temperature (°C)

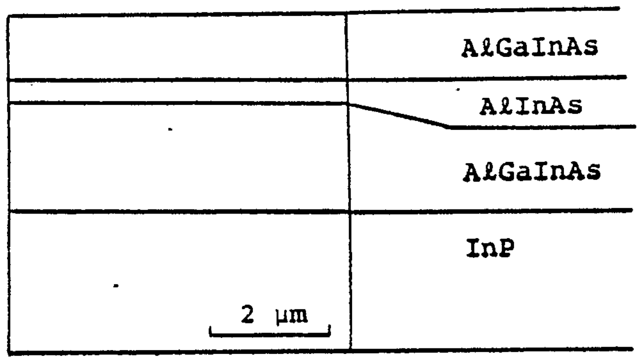


Fig. 11

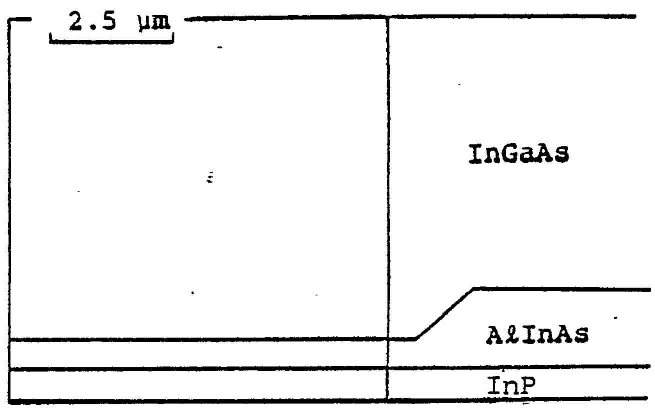


Fig. 12

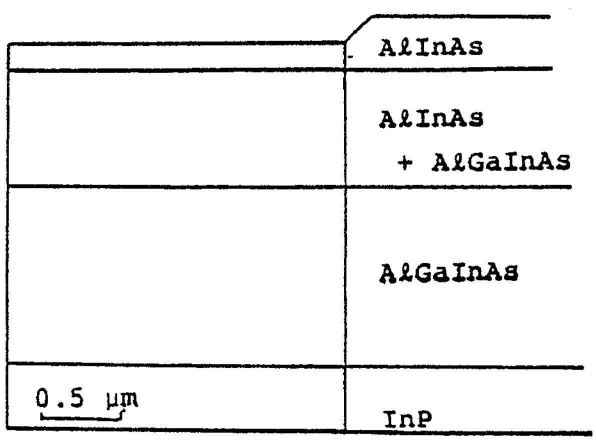


Fig. 13

Fig. 14

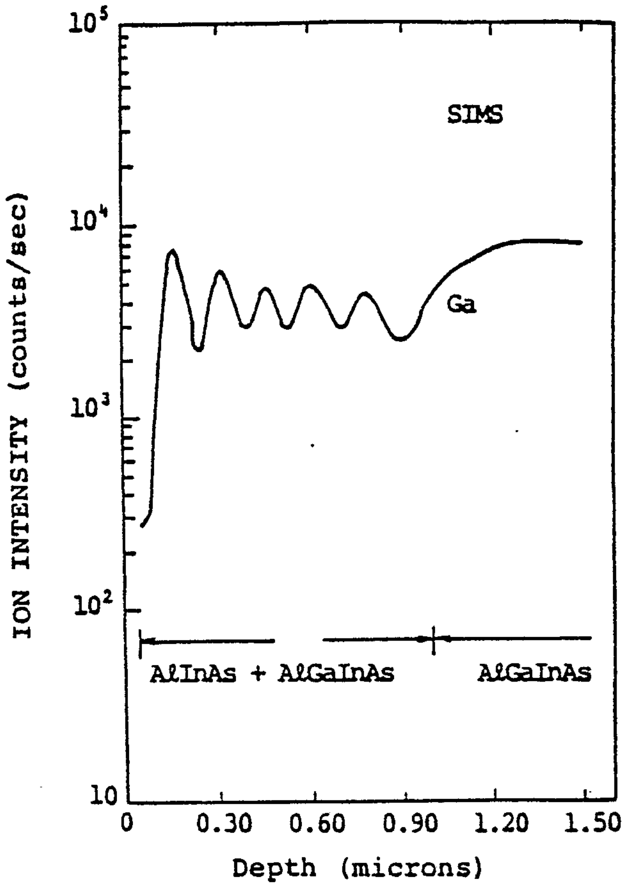

$10^5$
$10^4$
$10^3$
$10^2$
10
SIMS
Ga
ION INTENSITY (counts/sec)
AℓInAs + AℓGaInAs
AℓGaInAs
0
0.30
0.60
0.90
1.20
1.50
Depth (microns)

Fig. 15